# EUROPEAN PATENT APPLICATION

(11) **EP 1 248 286 A2**
(43) Date of publication of application: **09.10.2002**
(21) Application number: 02251966.4
(22) Date of filing: 19.03.2002
(51) Int. Cl.: H01L 21/00

(54) **Wet process station with water spray of wafer reverse side**

(30) Priority: 02.04.2001 US 822077
(71) Applicant: Reynolds Tech Fabricators, Incorporated, East Syracuse, New York 13057 (US)
(72) Inventor: Reynolds, Harold Vincent, Marcellus, New York 13108 (US)
(74) Representative: Hackney, Nigel John

(57) **Abstract**

An arrangement for wet-etching a semiconductor wafer (28) simultaneously subjects the reverse side to a water rinse. The wafer (28) is placed face down on top of a cylindrical tower (18), and an etchant such as hydrofluoric acid is sprayed up against that face through a nozzle (30) at the base of the tower (18). On the upper side of the wafer another water jet (42) flows deionized water onto the wafer to shield the upper surface from any vapors that may escape around the seal. An exhaust vent arrangement (48) surrounding the tower pulls air and any stray etchant vapors radially outward from the vicinity of the wafer (28).

## Description

This invention relates to wet process chemistry treatment of substrates, e.g., semiconductor wafers, ceramic wafers, and the like, and is more particularly directed to a technique for etching or otherwise treating an article with a caustic or corrosive reagent in a fashion that minimizes risk to the reverse side of the article.

An etching step is used at some stage of the fabrication of microcircuitry products from semiconductor material, for example, to remove material through a mask that has been applied onto a wafer of the semiconductor material. This typically involves a highly caustic or corrosive reagent, such as hydrofluoric acid (HF) in an aqueous solution. This can be followed by a coarse rinse at the same station. In a typical acid etch set-up, the semiconductor wafer is held face-up on a chuck, e.g., a vacuum chuck, and the etchant solution, such as HF or another reagent, is flowed or sprayed onto the exposed top surface. There is typically a gasket on the chuck to seal off the back side. However, the liquid reagent can flow around onto the back side and erode a marginal area of the wafer. Moreover, the HF is quite volatile, and fumes or vapors will be present that can also attack the material on the back side. The vacuum that holds the wafer onto the chuck can actually facilitate the migration of these vapors around the gasket and onto the back of the wafer.

It is common practice to employ a jet of a dry neutral gas, e.g., N₂, to prevent the treatment solution from flowing onto the reverse side of the wafer.

One prior approach to a wet treatment station is discussed in Aigo U.S. Pat. No. 4,600,463. In this approach, the wafer is held face-down on a basin, and there is a hole that permits flow of the etchant across the bottom surface of the semiconductor wafer. Nitrogen gas is fed into an upper part of the structure to flow against the upper surface of the wafer. Bonii U.S. Pat. No. 4,350,562 describes another etching technique, where the wafer is suspended face-up on a turntable on a cushion of neutral gas, and the upper surface is sprayed with the etchant solution. The wafer is rotated in an attempt to centrifuge the solution. Sumnitsch U.S. Pat. No. 4,903,717 describes a similar arrangement in which the wafer is supported on a gas cushion on a turntable.

In the prior art it has not been possible to completely avoid exposing the reverse side of the wafer to the corrosive treatment solutions, and none of the prior proposals have any provision to draw away the caustic or corrosive vapors, such as HF vapors.

Preferably, it is an object of this invention to provide a wet treatment station for etching or otherwise treating a silicon wafer or other substrate, and in which the etchant or treatment solution is prevented from reaching the back side of the wafer.

Preferably, it is another object of the invention to prevent vapors of fumes of the reagent used in treatment of the wafer from reaching the reverse side of the wafer.

According to one aspect of the present invention, a wet process station is provided for etching or otherwise treating a wafer. The wafer can be round or of another predetermined geometrical profile, and has an area to be treated on a face side. At the wet process station there is a basin or tray, with a generally open top side, and with a bottom and side walls. A tower is situated disposed in said basin, projecting upwards from the bottom, and has an open core and a top opening. The top opening matches the geometric profile of the wafer, and has a gasket or seal ring that the wafer presses against. The wafer is placed face-down onto the top opening of the tower. A hold-down or keeper descends upon the wafer after the latter is positioned at the top opening, and holds the wafer gently in place. An etchant jet or nozzle within the core of the tower directs a jet of aqueous solution upwardly against the lower face of the wafer. This jet may be an etchant, such as hydrofluoric acid, and may be followed by a coarse rinse of de-ionized water, sprayed through the same nozzle. The solution then drains out of the tower core via an etchant drain. Above the wafer, and mounted on the hold down or keeper is a rinse water sprayer. This produces a flow of de-ionized water onto the back or upper surface of the wafer, and this flow of water entrains any of the etchant that may escape from under the wafer. This rinse water flows out of the basin through a drain in said basin bottom. A vacuum or exhaust plenum is disposed on said basin side walls and has openings facing towards the tower. This draws the vapors off and transports them radially away from the wafer, by pulling out air and any entrained vapors that may have escaped from under the wafer. Thus, the water rinse and exhaust plenum here deal with any stray etchant liquid or vapors that may have escaped past the gasket or seal, and takes them away from the wafer. The risk of corrosion of the wafer back surface is minimized.

In one preferred arrangement, the hold down has a group of fingers that are joined to a central vertical member, which may be a rod. This arrangement can be swung out of the way so that the wafer can be robotically removed and replaced at the station. The hold down can also include a spray shield, i.e., a shroud in the form of an inverted cup to keep water or other chemical spray from splashing upwards into other areas of the equipment.

The above and many other objects, features, and advantages of this invention will become more fully appreciated from the ensuing detailed description of a preferred embodiment, which is to be considered in conjunction with the accompanying Drawing

### Brief Description of the Drawing

Fig. 1 is a perspective view of a wet process etch station arrangement according to one preferred embodiment of this invention.

Fig. 2 is a sectional elevation of this embodiment.

### Detailed Description of a Preferred Embodiment

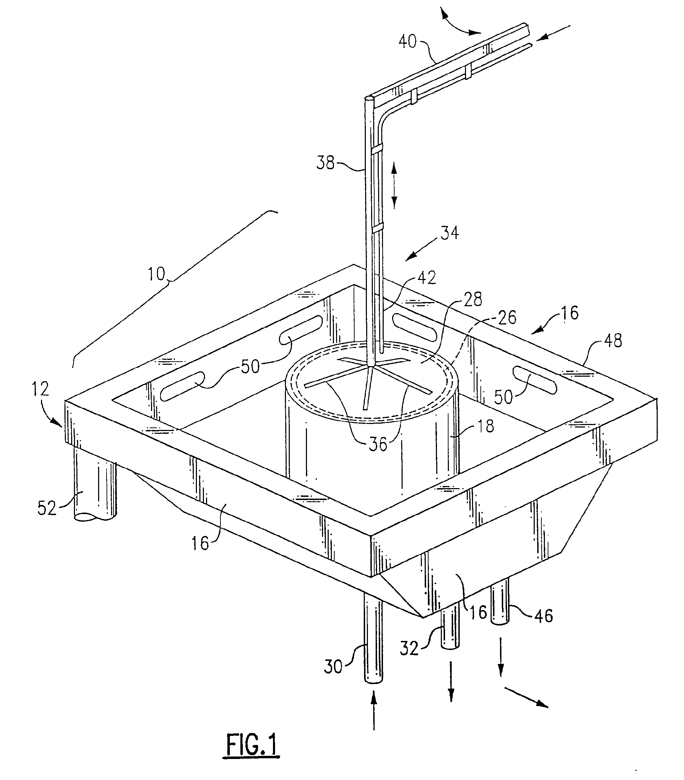

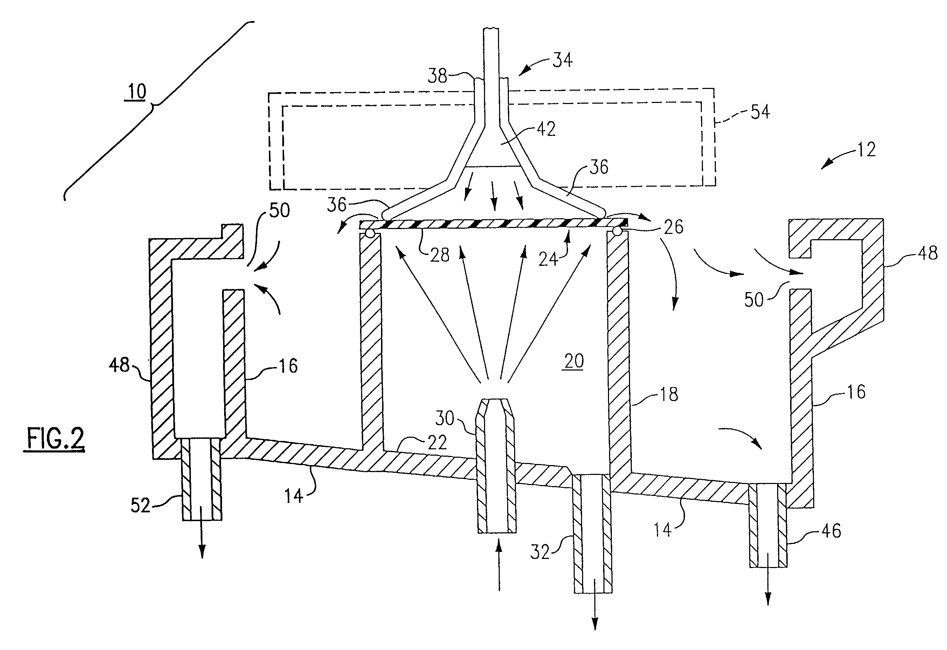

A wet process treatment, i.e., an acid etch station 10 according to an embodiment of this invention is illustrated in Figs. 1 and 2. Although not shown here, the arrangement 10 can be disposed within a cabinet, with a clean air system and automatic wafer handling equipment so that the plating, and possibly other process steps, are carried out automatically for a number of wafers or other workpieces in sequence. The system also includes fluid treatment and replenishment equipment, which is not shown here but would be understood by those skilled in this art. The etching station 10 employs a basin 12 which is preferably formed of a durable non-reactive, non-conductive material such as polypropylene or another suitable, tough plastic. The basin 12 has a bottom wall 14 that is sloped for drainage purposes (in Fig. 2, shown as sloping to the right) and side walls 16. The top of the basin 12 is open. Disposed centrally in the basin is a cylindrical tower 18, here with a circular cross section to accommodate a circular substrate or workpiece. The tower 18 has an open core or interior 20, and a base 22 that closes it off at the bottom. A top opening 24 is circular to accommodate a round workpiece, but could be another shape if need be. There is a gasket 26 or sealing ring at the top edge of the tower just outside the opening 24. A substrate 28, e.g., a silicon wafer, is positioned face-down onto the opening 24 on the cylindrical tower 18.

Inside the cylindrical tower is a nozzle 30 supplied with the treatment chemicals that are to be sprayed onto the downward face of the substrate 28. In this case, the nozzle penetrates upward through the base 22 and directs a jet or spray of the solution upwards. There is an etchant drain 32 at the downward side of the base 22 to collect the solution and return it to processing equipment (not shown).

A keeper or hold-down assembly 34 is provided for holding down the substrate 28 in place on the tower 18. In this embodiment, the keeper 34 comprises a group of fingers 36 that fan out from a central member in the form of a vertical rod 38. The rod 38 is supported on a swing arm 40 that swings the keeper out of the way for loading.and unloading. The keeper is also capable of a degree of up-and-down motion.

A water spray nozzle 42 is disposed on the keeper 34 above the wafer 28, and includes a feed hose 44 that is supported on the rod 38 and swing arm 40. The water spray nozzle 42 serves to flow de-ionized water over the upper or back surface of the wafer as a protective measure during an etch operation. A water drain 46 is provided at the bottom 14 of the basin 12, outside the tower 18. This drain 46 collects the deionized water that comes from the nozzle 42 and carries it to rinse treatment equipment (not shown).

An exhaust plenum 48 is disposed on the side walls 16 of the basin, and has exhaust slots 50 disposed on an inward facing side, i.e., facing towards the tower 18 and the substrate 28. A conduit 52 leads from the plenum 48 to a vacuum inducer fan (not shown), and to other equipment for capturing chemicals in the pumped-out air. The exhaust plenum 48 may exist on three of the four side walls 16, or may extend along all four walls.

An optional safety shroud 54, shown in ghost lines in Fig. 2, is here shown as a disk with depending rim, i.e., an inverted cup. This safety shroud is at least co-extensive with the opening 24 at the top of the tower 18. This shroud is intended to block any spray of etchant onto persons or equipment in the case where the substrate 28 is absent or is improperly positioned.

The operation of this etch station may be easily explained. First, with the hold-down 34 disposed to one side, a wafer 28 is placed robotically onto the tower 18 against the gasket 26, and centered on the top opening 24. The hold down or keeper 34 swings back into place and descends to hold the workpiece (i.e., the wafer 28) in place on the gasket 26.

An etchant solution, i.e., an aqueous solution of HF, is fed to the nozzle 30, and a spray of this solution is directed to the face or underside of the wafer 28. At the same time, the nozzle 44 floods the upper side of the wafer 28 with de-ionized water. The water runs over the edge of the wafer, and falls to the bottom 14 of the basin 12. There, this rinse water drains through the drain 46. The water from the nozzle 44 carries any HF and any other chemicals that may have escaped past the seal 26. The vacuum that is applied to the plenum 48 draws air from around the wafer 28 towards the slots 50, as shown in arrows in Fig. 2, and this air flow carries away any HF vapors that become entrained in the air. The water flooding the top of the wafer 28 and the air flow towards the vacuum plenum together keep any liquid or vapor etchants from attacking the upper side of the wafer.

After the etching is finished, de-ionized water is applied to the nozzle 30, and a coarse rinse of the under side of the substrate 28 is carried out. The protective water flow and vacuum are applied as above.

Thereafter, the water flow to the nozzle 42 is shut off, and the keeper 34 is lifted and swung out to the side. The wafer 28 is then robotically transferred to a subsequent station (not shown) and is replaced with another wafer that is to be etch treated.

It is also possible to apply some vacuum to the interior or core 20 of the tower 18, so that any leakage of air or other materials past the gasket or seal 26 will be in the inward direction, preventing the etchant from escaping. In addition, the shape and action of the keeper may vary from the specific design shown in connection with this embodiment.

Various sensors, gauges, and controls relating to pressure, flow rates, pH, and the like, which are not shown here, may be included at appropriate locations within the etching station 10. The drains shown here would connect with return conduits to pump, filtration, and fluid conditioning equipment, as appropriate to the chemistry involved.

The etching operation can employ an acid etch, followed by a coarse rinse with deionized water, or may employ treatment with other aqueous solutions either alone or in a combination or sequence, as required by the materials and chemistry involved.

While the invention has been described with reference to a preferred embodiment, it should be recognized that the invention is not limited to that precise embodiment, or to the variations herein mentioned. Rather, many modifications and variations would present themselves to persons skilled in the art.

## Claims

1. A wet process station for treatment of a wafer of a predetermined geometrical profile with an aqueous solution, in which:
a basin (12) has a generally open top, a bottom (14), and side walls (16);
a tower (18) is disposed in said basin, and has a top opening that matches the geometric profile of the wafer (28);
a hold-down (34) descends upon the wafer (28) positioned on the top opening of said tower (18) to hold the wafer in place thereon;
an etchant drain (32) permits draining of said solution from the core (20) of the tower;
a rinse water sprayer (42) is positioned above said tower and flows water onto an upper surface of the wafer (28); and
a rinse water drain (46) in said basin bottom outside said tower allows drainage of rinse water therefrom; and
**characterized in that** said tower (18) has an open core ( 20); an etchant jet (30) within the core of said tower directs a jet of said aqueous solution upwardly upon a lower surface of said wafer (28) in place on said tower; and a vacuum manifold (48) is disposed on said basin side walls (16) with openings (50) facing said tower that draw air and any entrained vapors away from said wafer (28).

2. The wet process station according to Claim 1 further **characterized in that** said tower includes a ring seal (26) disposed at an upper edge surrounding said top opening.

3. The wet process station according to Claim 1 further **characterized in that** said hold down comprises a plurality of fingers (36) joined to a central vertically movable member.

4. The wet process station according to Claim 3 further **characterized in that** said rinse water sprayer (42) is supported on said central vertically movable member (34).

5. The wet process station according to Claim 1 further **characterized in that** said tower (18) is centrally disposed in said basin (12).

6. The wet process station according to Claim 1 further **characterized in that** said tower is cylindrical.

7. The wet process station according to Claim 1 further **characterized in that** said vacuum manifold (48) includes manifold members disposed on at least three of the side walls (16) of said basin.

8. The wet process station according to Claim 1 further **characterized in that** said vacuum manifold (48) has exhaust slots (50) facing said tower (18).

9. The wet process station according to Claim 4 further **characterized in that** a spray shield (54) is disposed on said hold down movable member above said tower.

10. The wet process station according to Claim 9 further **characterized in that** said spray shield (54) comprises an inverted cup member.
